# EUROPEAN PATENT APPLICATION

(11) **EP 3 389 095 A1**
(43) Date of publication of application: **17.10.2018**
(21) Application number: 17166307.3
(22) Date of filing: 12.04.2017
(51) Int. Cl.: H01L 29/78, H01L 21/336

(54) **MANUFACTURING METHOD FOR A FINFET, FINFET AND DEVICE COMPRISING A FINFET**

(71) Applicant: ASML Netherlands B.V., 5500 AH Veldhoven (NL)
(72) Inventor: DE POORTERE, Etienne, 5500 AH Veldhoven (NL)
(74) Representative: Peters, John Antoine

(57) **Abstract**

A method of manufacturing a fin field effect transistor (finFET) is described, the method comprising the steps of:
- providing a substrate with a semiconductor layer of a first material;
- removing portions of the semiconductor layer to form a fin of the first material and a trench;
- growing alternating layers of the first material and a second material in the trench adjacent the fin;
- removing portions of the alternating layers to form a lateral fin adjacent to the fin, the lateral fin comprising a stack comprising alternating portions of the first material and portions of the second material;
- removing the portions of second material so as to obtain a fin structure comprising the fin and one or more lateral fin portions formed by the portions of the first material.

## Description

### FIELD OF THE INVENTION

The present invention relates to a method of manufacturing a finFET, a finFET and a device comprising a finFET.

### BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

Lithographical apparatuses as described may e.g. be applied in the manufacturing process of semiconductor components such as finFETs.

A finFET is a component having a channel connecting a source and a drain, the channel typically comprising a thin vertical semiconductor structure, referred to as the fin, which may be enclosed on one or more sides by a gate, the gate being configured to modulate the channel. In order to improve the electrical properties of the FET the use of nanowires or nanosheets has been proposed. The nanowire or nanosheet architecture however suffers from the drawback that its manufacturing process is significantly more complex, due to the fact that the nanowires/nanosheets need to be disconnected from each other. In addition, for a given available top-down area for the channel and a given device height, the current that can be drawn from a channel having a nanowire/nanosheet architecture will typically be lower than the current that can be drawn from a channel having a fin-shaped cross-section.

### SUMMARY OF THE INVENTION

It is desirable to realize an improved finFET in which one or more of the mentioned drawbacks is mitigated.

According to an aspect of the present invention, there is provided a method of manufacturing a fin field effect transistor (finFET), the method comprising the steps of:
- providing a substrate comprising a first material;
- removing portions of the first material to form a fin of the first material and a trench adjacent the fin;
- growing alternating layers of a second material and of the first material or a third material in the trench adjacent the fin;
- removing portions of the alternating layers to form a lateral fin adjacent to the fin, the lateral fin comprising alternating portions of the first material or the third material and portions of the second material;
- in case the lateral fin comprises portions of the third material:
   - removing the portions of the third material, and
   - growing portions of the first material where the portions of the third material were removed;
- removing the portions of second material so as to obtain a fin structure comprising the fin and one or more lateral fin portions formed by the portions of the first material.

According to another aspect of the present invention, there is provided a method of manufacturing a fin field effect transistor (finFET), the method comprising the steps of:
- providing a substrate comprising a first material;
- growing a stack of alternating layers of a second material and the first material or a third material on a surface of the first material;
- removing portions of the stack to form a fin shaped cavity;
- growing a fin of the first material inside the fin shaped cavity;
- removing portions of the stack of alternating layers to form a lateral fin adjacent to the fin, the lateral fin comprising alternating portions of the first material or the third material and portions of the second material;
- in case the lateral fin comprises portions of the third material:
   - removing the portions of the third material, and
   - growing portions of the first material where the portions of the third material were removed;
- removing the portions of second material so as to obtain a fin structure comprising the fin and one or more lateral fin portions formed by the portions of the first material.

According to yet another aspect of the present invention, there is provided a finFET comprising:
a channel connecting a source and a drain, the channel comprising a fin structure, whereby the fin structure comprises a fin and one or more lateral fin portions.

### BRIEF DESCRIPTION OF THE DRAWINGS

Embodiments of the invention will now be described, by way of example only, with reference to the accompanying schematic drawings in which corresponding reference symbols indicate corresponding parts, and in which:
- Figure 1 depicts a lithographic apparatus according to an embodiment of the invention;
- Figure 2 depicts a manufacturing process of a finFET according to the present invention.
- Figure 3 depicts another manufacturing process of a finFET according to the present invention.
- Figure 4 depicts three embodiments of fin structures as can be obtained by means of the manufacturing process according to the present invention.
- Figure 5 depicts three prior art or proposed channel structures and an embodiment of a fin structure according to the present invention.

### DETAILED DESCRIPTION

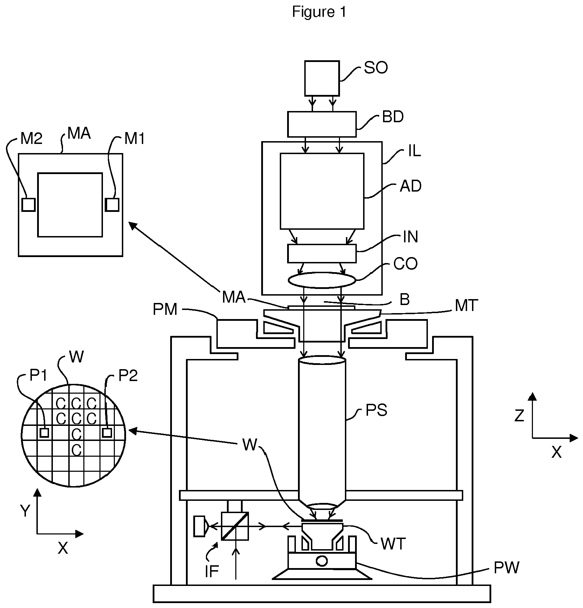

Figure 1 schematically depicts a lithographic apparatus according to one embodiment of the invention. The lithographic apparatus comprises an illumination system IL, a support structure MT, a substrate table WT and a projection system PS. The illumination system IL is configured to condition a radiation beam B. The support structure MT is constructed to support a patterning device MA and is connected to a first positioning device PM configured to accurately position the patterning device MA in accordance with certain parameters. The substrate table WT is constructed to hold a substrate W, e.g., a resist-coated wafer, and is connected to a second positioner PW configured to accurately position the substrate W in accordance with certain parameters. The projection system PS is configured to project a pattern imparted to the radiation beam B by patterning device MA onto a target portion C (e.g. comprising one or more dies) of the substrate W.

The illumination system IL may include various types of optical components, such as refractive, reflective, magnetic, electromagnetic, electrostatic or other types of optical components, or any combination thereof, for directing, shaping, or controlling radiation.

The illumination system IL receives the radiation beam B from a radiation source SO. The radiation source SO and the lithographic apparatus may be separate entities, for example when the radiation source SO is an excimer laser. In such cases, the radiation source SO is not considered to form part of the lithographic apparatus and the radiation beam B is passed from the radiation source SO to the illumination system IL with the aid of a beam delivery system BD comprising, for example, suitable directing mirrors and/or a beam expander. In other cases the radiation source SO may be an integral part of the lithographic apparatus, for example when the radiation source SO is a mercury lamp. The radiation source SO and the illumination system IL, together with the beam delivery system BD if required, may be referred to as a radiation system.

The illumination system IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illumination system IL can be adjusted. In addition, the illumination system IL may comprise various other components, such as an integrator IN and a condenser CO. The illumination system IL may be used to condition the radiation beam B, to have a desired uniformity and intensity distribution in its cross-section.

The term "radiation beam" used herein encompasses all types of electromagnetic radiation, including ultraviolet (UV) radiation (e.g. having a wavelength of or about 365, 355, 248, 193, 157 or 126 nm) and extreme ultra-violet (EUV) radiation (e.g. having a wavelength in the range of 5-20 nm), as well as particle beams, such as ion beams or electron beams.

The support structure MT supports, i.e. bears the weight of, the patterning device MA. The support structure MT holds the patterning device MA in a manner that depends on the orientation of the patterning device MA, the design of the lithographic apparatus, and other conditions, such as for example whether or not the patterning device MA is held in a vacuum environment. The support structure MT can use mechanical, vacuum, electrostatic or other clamping techniques to hold the patterning device MA. The support structure MT may be a frame or a table, for example, which may be fixed or movable as required. The support structure MT may ensure that the patterning device MA is at a desired position, for example with respect to the projection system PS.

The term "patterning device" used herein should be broadly interpreted as referring to any device that can be used to impart a radiation beam with a pattern in its cross-section such as to create a pattern in a target portion C of the substrate W. It should be noted that the pattern imparted to the radiation beam B may not exactly correspond to the desired pattern in the target portion C of the substrate W, for example if the pattern includes phase-shifting features or so called assist features. Generally, the pattern imparted to the radiation beam B will correspond to a particular functional layer in a device being created in the target portion C, such as an integrated circuit.

The patterning device MA may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in the radiation beam B which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum.

As here depicted, the lithographic apparatus is of a transmissive type (e.g. employing a transmissive mask). Alternatively, the lithographic apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure. An additional table may be arranged to hold at least one sensor, instead of holding a substrate W. The at least one sensor may be a sensor to measure a property of the projection system PS, a sensor to detect a position of a marker on the patterning device MA relative to the sensor or may be any other type of sensor. The additional table may comprise a cleaning device, for example for cleaning part of the projection system PS or any other part of the lithographic apparatus.

The lithographic apparatus may also be of a type wherein at least a portion of the substrate W may be covered by a liquid having a relatively high refractive index, e.g. water, so as to fill a space between the projection system PS and the substrate W. An immersion liquid may also be applied to other spaces in the lithographic apparatus, for example, between the patterning device MA and the projection system PS. Immersion techniques are well known in the art for increasing the numerical aperture of projection systems. The term "immersion" as used herein does not mean that a structure, such as a substrate W, must be submerged in liquid, but rather only means that liquid is located between the projection system PS and the substrate W during exposure.

The radiation beam B is incident on the patterning device MA, which is held on the support structure MT, and is patterned by the patterning device MA. Having traversed the support structure MT, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module and a short-stroke module, which form part of the first positioner PM. The long-stroke module provides movement of the support structure MT over a large range with limited accuracy (coarse positioning), whereas the short-stroke module provides movement of the support structure MT relative to the long-stroke module over a small range with high accuracy (fine positioning). Similarly, movement of the substrate table WT may be realized using a long-stroke module and a short-stroke module, which form part of the second positioner PW. In the case of a stepper (as opposed to a scanner) the support structure MT may be connected to a short-stroke actuator only, or may be fixed.

Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions C. Substrate alignment marks P1, P2 are known as scribe-lane alignment marks, when they are located in spaces between the target portions C. Similarly, in situations in which more than one die is provided on the patterning device MA, the mask alignment marks M1, M2 may be located between the dies.

The depicted apparatus could be used in at least one of the following modes:

In a first mode, the step mode, the support structure MT and the substrate table WT are kept essentially stationary, while an entire pattern imparted to the radiation beam B is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.

In a second mode, the scan mode, the support structure MT and the substrate table WT are scanned synchronously while a pattern imparted to the radiation beam B is projected onto a target portion C (i.e. a single dynamic exposure). The velocity and direction of the substrate table WT relative to the support structure MT may be determined by the (de-)magnification and image reversal characteristics of the projection system PS. In scan mode, the maximum size of the exposure field limits the width (in the non-scanning direction) of the target portion C in a single dynamic exposure, whereas the length of the scanning motion determines the height (in the scanning direction) of the target portion C.

In a third mode, the support structure MT is kept essentially stationary holding a programmable patterning device MA, and the substrate table WT is moved or scanned while a pattern imparted to the radiation beam B is projected onto a target portion C. In this mode, generally a pulsed radiation source is employed and the programmable patterning device MA is updated as required after each movement of the substrate table WT or in between successive radiation pulses during a scan. This mode of operation can be readily applied to maskless lithography that utilizes programmable patterning device, such as a programmable mirror array of a type as referred to above.

The lithographic apparatus further includes a control unit which controls the actuators and sensors described. The control unit also includes signal processing and data processing capacity to implement desired calculations relevant to the operation of the lithographic apparatus. In practice, the control unit will be realized as a system of many sub-units. Each sub-unit may handle the real-time data acquisition, processing and/or control of component within the lithographic apparatus. For example, one sub-unit may be dedicated to servo control of the second positioner PW. Separate sub-units may handle the short-stroke module and the long-stroke module, or different axes. Another sub-unit may be dedicated to the readout of the position sensor IF. Overall control of the lithographic apparatus may be controlled by a central processing unit, communicating with the sub-units, with operators and with other apparatuses involved in the lithographic manufacturing process.

Combinations and/or variations on the above described modes of use or entirely different modes of use may also be employed.

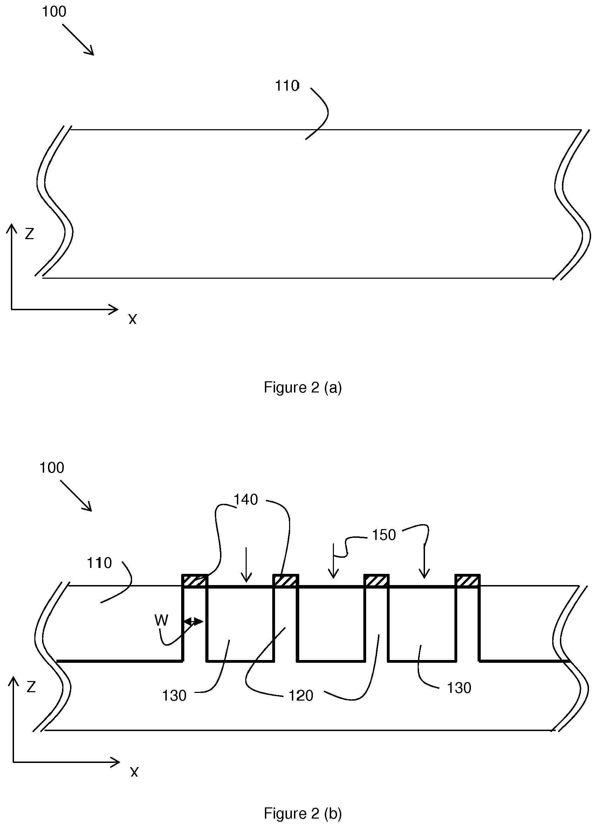

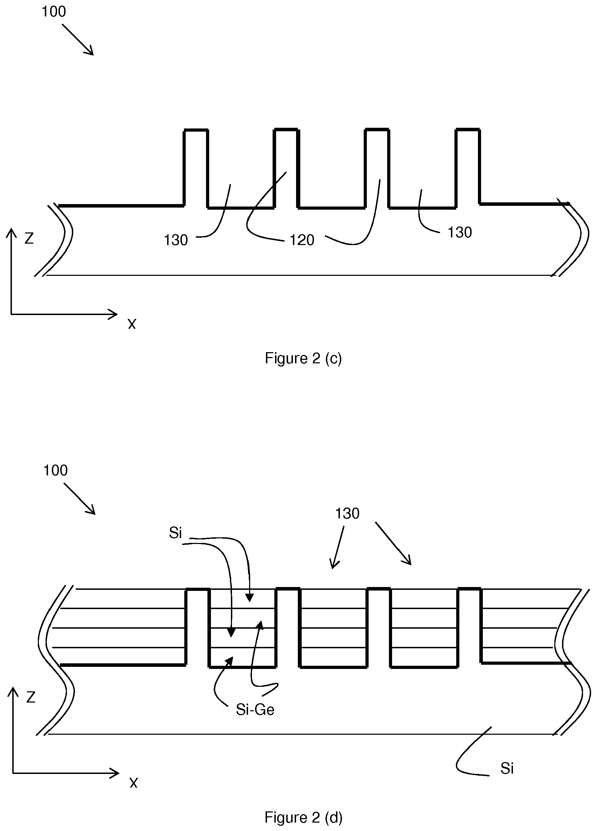

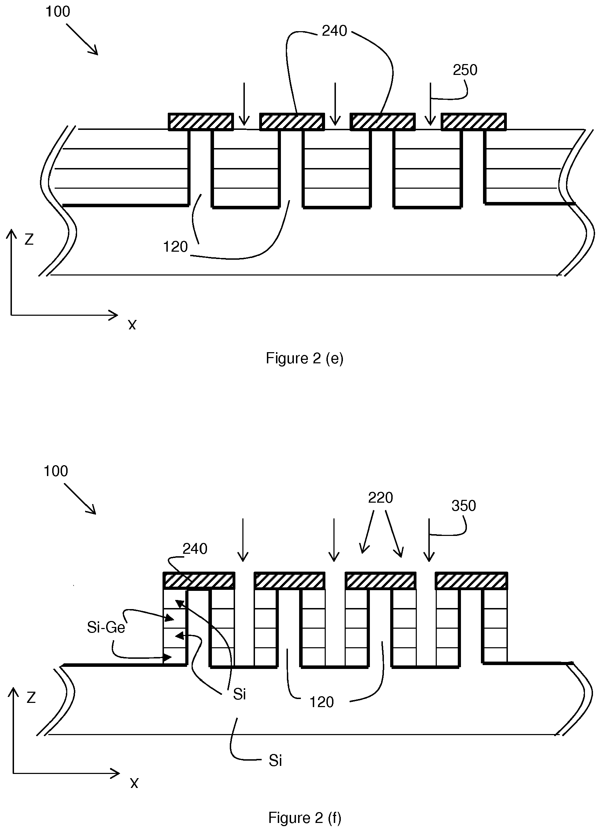

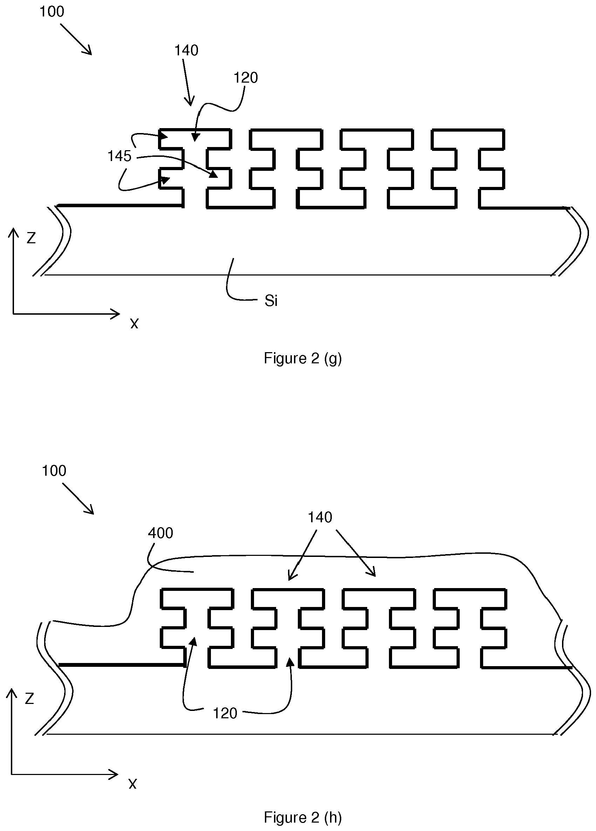

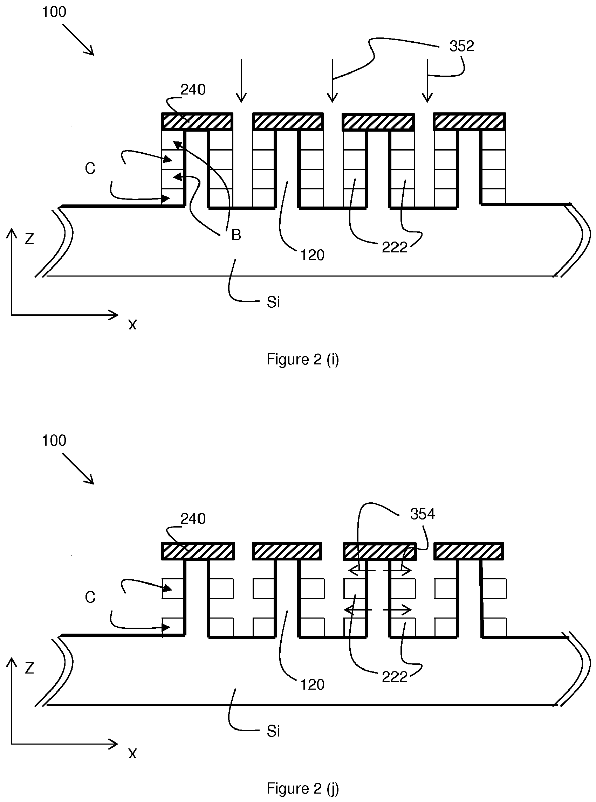

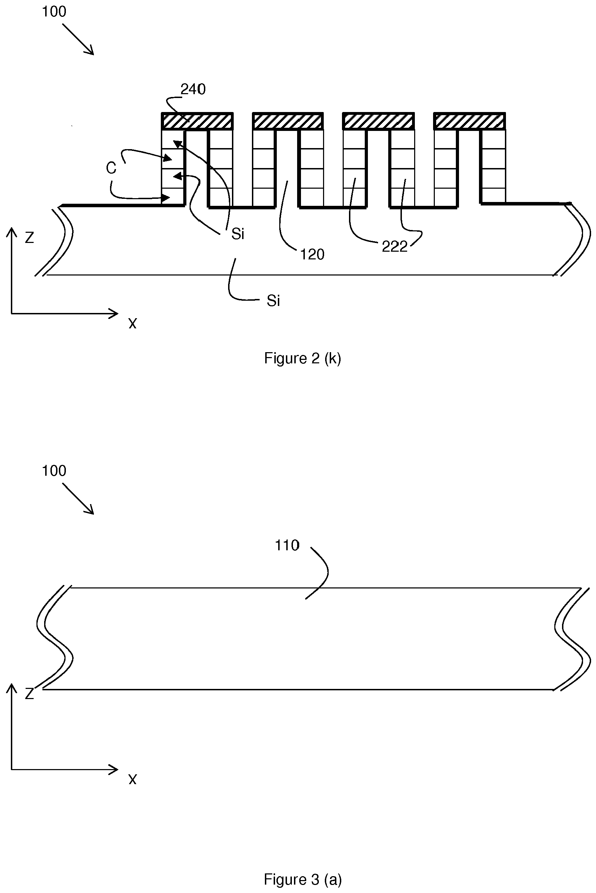

Figure 2 depicts a manufacturing process for a finFET according to an embodiment of the present invention.

Figure 2 (a) schematically depicts a semiconductor substrate 100 comprising a first material 110, e.g. a silicon substrate that can be applied to manufacture a finFET.

In a first step of the manufacturing process according to the present invention, illustrated in Figure 2 (b), portions of the first material 110 are removed so as to form a fin 120 and a trench 130. In general, a fin refers to a structure having a certain height, in the indicated Z-direction, and extending in a longitudinal direction perpendicular to the plane of the drawing. In the embodiment as shown, the fin 120 has a width W in a direction perpendicular to the longitudinal direction, i.e. the X-direction, also referred to as the lateral direction. In the embodiment as shown, four fins 120, separated by trenches 130 are schematically shown. Such a structure may e.g. be realized by applying a hard mask 140 onto the substrate layer and etching material that is not covered by the mask (the etching being indicated by the arrows 150). The resulting structure is schematically shown in Figure 2 (c). In a next step of the manufacturing method according to the present invention, layers of the same material as the first material 110 and layers of another material are alternatingly grown or deposited in the trench or trenches. Alternately, as will be explained in more detail below, alternating layers of two different materials, both being different from the first material that is used to form the fin, are deposited in the trench or trenches. By doing so, a structure known as a superlattice is obtained in the trenches. In an embodiment, the materials as applied to grow the alternating layers have different properties with respect to etching. In an embodiment, the first material may e.g. be silicon (Si), whereas the other material is silicon-germanium (SiGe).

Figure 2 (d) schematically shows the trenches 130 being provided with alternating layers of a first material (Si) and a second material (SiGe). In the example shown, the first material 110 is assumed to be Si, as indicated.

In a next step of the manufacturing process according to the present invention, portions of the alternating layers are removed, thereby forming a lateral fin or lateral fins adjacent to the already existing fins, the lateral fin or fins comprising a stack which comprises alternating portions of the first material (e.g. Si) and portions of the second material. The removal of the portions of the alternating layers may be realized by applying a hard mask 240 covering the fins and part of the alternating layers and subsequently etching the portions of the alternating layers that are not covered by the hard mask 240 (the etching being indicated by the arrows 250). This process is schematically illustrated in Figure 2 (e).

As a result of the masking and etching steps illustrated in Figure 2 (e), a structure as shown in Figure 2 (f) is obtained. In the embodiment as shown, two lateral fins 220 are provided adjacent each fin 120, the two lateral fins being arranged adjacent opposite sides of the fin 120. In accordance with the present invention, a lateral fin refers to a fin positioned adjacent a fin in the lateral direction, i.e. the indicated X-direction, perpendicular to the longitudinal direction. In the embodiment as shown, lateral fins 220 are created adjacent the existing fins 120, the lateral fins having alternating portions of silicon (Si) and silicon-germanium (SiGe.) In a next step of the manufacturing process according to the present invention, a selective etching, indicated by the arrows 350 is applied to remove the portions of the lateral fins 220 that are made of the second material (SiGe). In general, the material of which the second portions of the lateral fin or fins 220 is made should be selected in such manner that it can be removed, e.g. by means of etching, while the portions of the lateral fins 220 that are made of the first material are substantially preserved. The resulting structure, after removal of the mask 240, is schematically shown in Figure 2 (g). As a result, a fin structure 140 is created comprising the fin 120 and one or more lateral fin portions 145 formed by the portions of the first material. In the embodiment as shown, four fin structures 140 are obtained.

The fin structure as shown in Figure 2 (g) may then be used as a channel in a finFET component. In order to do so, the manufacturing process according to an embodiment of the present invention further comprises the step of providing an insulation layer on the fin structure e.g. by means of an oxide deposition. The manufacturing process according to the present invention may further comprise the step of depositing an insulator and a gate on the fin structure, the gate being e.g. a highly n+-doped poly silicon layer, or containing metals such as Al or Ti, see e.g. T. Skotnicki, et al., (STMicroelectronics) T-ED, vol. 55, no. 1, p. 96, 2008. Alternatively, a sacrificial material may be applied, having the desired gate geometry, the sacrificial material being replaced by the actual gate at a later step.

Figure 2 (h) schematically shows the fin structure as can be obtained by the manufacturing process according to the present invention, combined with a gate 400. Alternative methods to arrive at a fin structure having one or more lateral fin portions will now be described.

In case the alternating layers as applied to realize the superlattice in the trench or trenches are made of two different materials, both being different from the first material that is used to form the fin, a fin structure as schematically shown in Figure 2 (h) may be obtained by the application of two additional manufacturing steps. These additional step are schematically illustrated in Figures 2 (i),(j) and (k).

In case the alternating layers as applied to realize the superlattice in the trench or trenches, are made of two different materials, referred to as materials B and C, both being different from the first material that is used to form the fin, a structure as schematically shown in Figure 2 (h) can be obtained by means of the processing steps as described above.

Figure 2 (i) schematically shows fins 120 made of Si, each fin having on both sides a lateral fin 222 comprising alternating portions of a material B, also referred to as the second material, and a material C, also referred to as the third material. A mask 240 is further shown, covering the fins 120 and lateral fins 222.

In a first additional step, the structure as schematically shown in Figure 2 (i) is subjected to an etching to remove the material B or second material (indicated by the arrow 352 in Figure 2 (i)), leaving only the lateral fin portions 222 of the material C or the third material.
The resulting structure is schematically shown in Figure 2 (j). In a second additional step, lateral fin portions of the first material, e.g. Si, are grown, where portions of the material B were removed. The lateral growth process being indicated by the arrows 354. Such a lateral growth of the lateral fin portions of the first material may e.g. be realized by epitaxy.
As a result, a structure as shown in Figure 2 (k) is obtained. Note that this structure is similar to the structure shown in Figure 2 (f), this structure have lateral fin portions of the same material as the fin 120, Si in the example shown.
Once these two additional steps are performed, the removal of the lateral fin portions of the material C, e.g. by etching and the removal of the hard mask 240 will result in the structure of Figure 2 (h).

The manufacturing process according to the present invention as described in Figures 2 (a) to(k) can be summarized as follows:
Starting from a substrate comprising a first material, the following steps are performed;
   - portions of the first material are removed, thereby forming a fin of the first material and a trench adjacent the fin;
   - alternating layers of a second material and the first material or alternating layers of a second material and a third material are grown in the trench adjacent the fin;
   - portions of the alternating layers are then removed, to form a lateral fin adjacent to the fin, the lateral fin comprising alternating portions of the first material or the third material and portions of the second material;
   - in case the lateral fin comprises portions of the third material, the portions of the third material are removed and replaced by portions of the first material by growing portions of the first material where the portions of the third material were removed;
   - finally, the portions of second material are removed, so as to obtain a fin structure comprising the fin of the first material and one or more lateral fin portions formed by the portions of the first material.

In the embodiment of the manufacturing method according to the present invention illustrated in Figures 2 (a) - (k), an array of fins separated by trenches filled with superlattices are applied. In the manufacturing process as illustrated, the process starts by etching the trenches in a substrate comprising a first material or a layer of a first material.

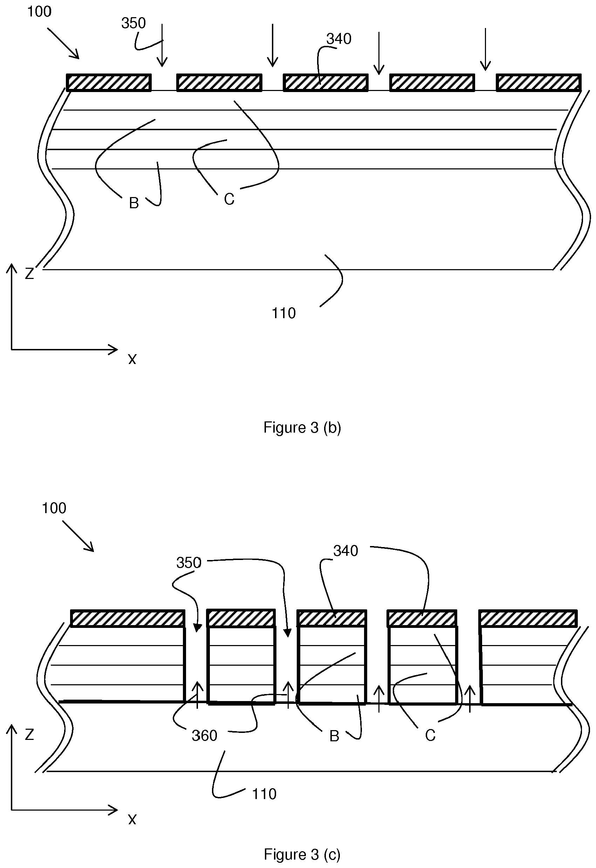

The array of fins and superlattices as applied may also be obtained in an alternative manner. This is illustrated in Figure 3.

Figure 3 (a) schematically depicts a semiconductor substrate 100 comprising a first material 110, e.g. a silicon substrate that can be applied to manufacture a finFET. In a first step of the alternative manner to arrive at an array of fins and superlattices, a stack of alternating layers of a second material and either the first material or a third material is deposited or grown on a surface of the first material 110. The first material may e.g. be in the shape of a layer. The resulting structure is schematically shown in Figure 3 (b), Figure 3 (b) illustrating a cross-sectional view through a semiconductor substrate 100 comprising a first material 110 and a stack of alternating layers of a second material (referred to as material B) and a third material (referred to as material C).

In a next step, fin shaped cavities are etched in the stack of alternating layers by removing portions of the first material 110. This can e.g. be done by the application of a hard mask 340 and a suitable etchant, indicated by the arrows 350. The resulting structure is schematically shown in Figure 3 (c). Figure 3 (c) schematically shows a portion of a semiconductor substrate 100 comprising a first material 110 and alternating layers of a second material (B) and of a third material (C) and fin shaped cavities 350, obtained by removing of portions of the first material 110, e.g. by means of etching, by an appropriate covering of the stack of layers by means of a hard mask 340.
As can be seen, the fin shaped cavities 350 extend to the surface of the first material 110; i.e. the etching 350 is preformed through the entire stack or superlattice of alternating layers of materials B and C.

In a next step, fins of the first material 110 are grown in the fin shaped cavities 350, indicated by the arrows 360 in Figure 3 (c). When the fins of the first material 110 are grown to the same height level as the upper layer of the stack of materials B and C, a structure similar to the structure shown in Figure 2 (d) is obtained. Note that the structure of Figure 2 (d) describes a stack of alternating layers of Si and SiGe, but, as described with reference to Figures 2 (i)-(k), a stack of alternating layers of materials B and C may be applied as well.

Once the fins are grown inside the fin shaped cavities, the process as described in Figures 2(e)-(g) or the process as described in Figures 2 (i) -(k) (followed by the process of Figure 2(f)), depending on whether the superlattice comprises layers of the first material or not, can be applied, ultimately resulting in fin structures as shown in Figure 2 (g).
With respect to the growing of the fins inside the fin shaped cavities, it can be pointed out that such a growth process may also be realized in case the material C would correspond to the first material 110 of the substrate. In that case, the growing process would not only start from the bottom of the fin shaped cavity but also from the side portions of the fin shaped cavity that are made of the first material.

Figure 2 (h) schematically shows the fin structure as can be obtained by any of the manufacturing process according to the present invention described above, combined with a gate 400. In the embodiment shown, the fin structures 140 are symmetrical about the fins 120. It can be pointed out that this is not required. Using the above described manufacturing method, and applying the appropriately sized hard masks, other fin structures may be realized as well.

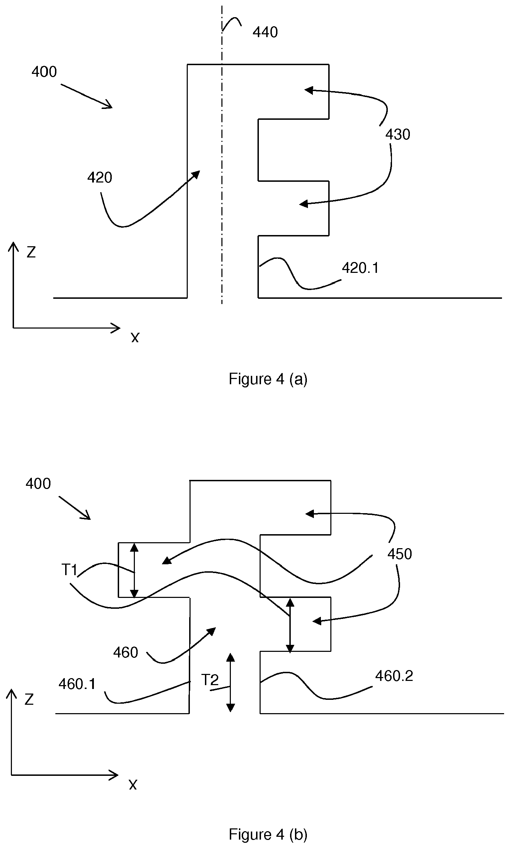

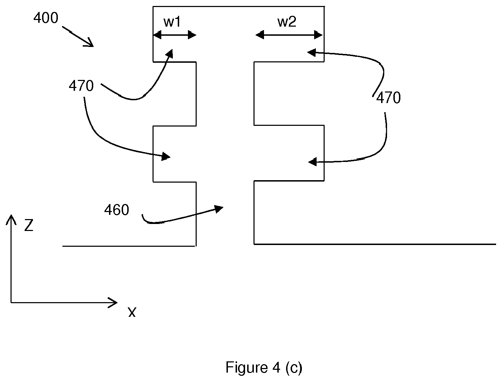

Figure 4 schematically shows three alternative fin structures 400 that may be realized using the manufacturing method according to the present invention. Figure 4 (a) shows a cross-sectional view of a fin structure 400 which can be applied as a channel in a finFET, the fin structure having a fin 420 comparable to fin 420 of Figure 2, and having two lateral fin portions 430 arranged on the same side 420.1 of the fin 420. In this respect, it can be noted that the fin structure as realized by means of the manufacturing method according to the present invention need not be symmetrical about a central axis, such as an axis 440 through the fin 420.

Further, as illustrated in Figure 4 (b), the number of lateral fin portions 450 on both sides of a central fin 460 of the fin structure 400 need not be the same. In the embodiment as shown, the fin structure 400 comprises one lateral fin portion adjacent side 460.1 of the central fin 460 and two lateral fin portions adjacent an opposite side 460.2 of the central fin 460. By applying the appropriate sequence of layers of the first material and of the second material, the vertical position, i.e. along the Z-direction, and thickness T1 of the lateral fin portions 450 can be selected. In order to realize such a structure, the stack of alternating layers or superlattice as applied on both sides of the fin 460 should be different. More specifically, the bottom layer of the stack of alternating layers should e.g. have a bottom layer having a thickness T1 +T2 on the left side and a layer having a thickness T2 on the right side. Such an asymmetric pair of superlattices can e.g. be realized by, in a first step, covering the right side trench and fin 460 with a hard mask. In a second step, depositing a layer of a second material, e.g. SiGe, as a bottom layer in the left side trench. In a third step, removing the mask and depositing the alternating stack of layers as required in both trenches, e.g. starting with a layer of SiGe.
By doing so, the bottom layer of SiGe in the left side trench will be thicker, enabling in an elevated position of the lateral fin portion on the left. As a result process, the lateral fin portions of the first material of the lateral fin on the left side can have a different vertical position than the lateral fin portions of the first material of the lateral fin on the right side of the fin 460.

It can be pointed out that such an arrangement, i.e. having an asymmetric positioning of the lateral fin portions on both sides of the central fin 460 may be advantageous since it reduced the distance of the inner material of the fin structure 400 to the gate surrounding the fin structure.

Further, as illustrated in Figure 4 (c), the width of the lateral fins 470 as applied on both sides of a central fin 460, w1, w2, need not be the same. Such a structure may e.g. be obtained by an asymmetrical positioning of a hard mask, such as hard mask to remove the stack.

The fin structures as can be obtained by means of the manufacturing method according to the present invention may provide several advantages over known fins or fin structures.

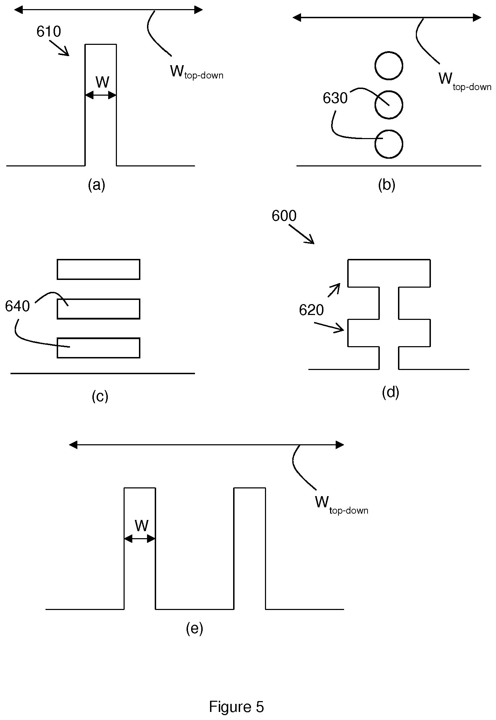

Figure 5 schematically shows three types of channel cross-sections as known in the art, shown in (a), (b) and (c) and a fin structure 600, shown in (d), as obtained by means of the manufacturing process according to the present invention. For each of the four structures, the same device height is assumed to be available; for (c) and (d), the top-down area , indicated by the width W_{top-down} is the same. To increase the cross-section of (a) and (b), a second fin or nanowire stack has to be added, with a gate separating the two fins or stacks, thereby increasing top-down area significantly, as illustrated in Figure 5 (e). Comparing the four structures, it can be pointed out that the largest channel cross-section may be realized by the fin structure 600 obtained by means of the manufacturing process according to the present invention. Note in this respect that, in order to switch properly, the fin or fin structure needs to be comparatively slim, in order for the material constituting the fin or fin structure to be close to the gate. Phrased differently, increasing the width W of the fin 610 shown in Figure 5 (a) would not necessarily result in an improved performance of the gate as the inner portion of such an enlarged fin would be further away from the gate. The fin structure 600 shown in Figure 5 (d) does not suffer from this drawback because the gate can extend in between the lateral fins 620, thus enabling all material of the channel to be close to the gate. Compared to the channel structures of Figures 5 (b) and 5 (c), illustrating respectively the use of nanowires 630 or nanosheets 640, the fin structure of Figure 5 (d) is believed to be more easily manufactured. In particular, the nanosheets and nanowires as shown in Figures 5 (b) and (c) need to be kept spaced apart and to be kept from collapsing during the manufacturing process. Because of this, the deposition of an isolation layer, e.g. a gate spacer dielectric isolating the gate from the source and the drain of the finFET, on the side of the gate (formed by the nanowires or nanosheets) may be difficult, due to the fact that the nanowires or nanosheets are spaced apart.

Another challenge in transistor technology is to increase the current drawn by the transistor, preferably without increasing the height of the transistor or the parasitic capacitance. Compared to the fin structures that can be realized by means of the manufacturing method according to the present invention, transistors having nanowires or nanosheets as a channel, both suffer from having a higher parasitic capacitance at a matched current. Further, the available cross-section of the fin structure 600, i.e. the cross-section available for a current through the channel formed by the fin structure, may be substantially larger than the cross-section of the combined nanowires 630 or combined nanosheets 640.

Further, compared to the conventional fin structure shown in Figure 5 (a), the manufacturing process according to the present invention enables the top-down width of the fin structure to be tuned to any desired need. Using the conventional fin structure 610 shown, a device size can only be tuned in discrete increments, i.e. one can implement an integer number of fins 610 to arrive at a desired channel cross-section. By means of the present invention, the cross-section of the fin structure, e.g. structure 620 may be tuned because the manufacturing method provides in the flexibility to select the number of lateral fin portions, the position of the lateral fin portions and the dimensions of the lateral fin portions, the latter two in a substantially continuous manner.

The manufacturing methods according to the present invention enable the manufacturing of a fin structure of a first material, whereby, during the process, a second and optionally a third sacrificial material is used, as described above. The following table indicates some possible combinations of three materials to arrive at the fin structure according to the present invention:

**Table 1:**

| First material (fin structure) | Material B | Material C |
|---|---|---|
| Si | AlN | GaAlN |
| SiGe | AlN | GaAlN |
| InGaAs | Si | SiGe |
| GaAs | Si | SiGe |

In an embodiment, the fin structure as obtained by means of a manufacturing process according to the present invention, e.g. fin structures 140, 300, 600 may have a height in a range between 40 nm and 100 nm, preferably in a range between 50 and 70 nm. In such embodiment, the one or more lateral fins, e.g. lateral fins 145, 330, 350, 370, 620 may e.g. have a width in a range between 3 nm and 15nm and a height between 3 and 10 nm.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate W referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate W may be processed more than once, for example in order to create a multi-layer IC, so that the term substrate W used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device MA defines the pattern created on a substrate. The topography of the patterning device may be pressed into a layer of resist supplied to the substrate whereupon the resist is cured by applying electromagnetic radiation, heat, pressure or a combination thereof. The patterning device MA is moved out of the resist leaving a pattern in it after the resist is cured.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

## Claims

1. A method of manufacturing a fin field effect transistor (finFET), the method comprising the steps of:
- providing a substrate comprising a first material;
- removing portions of the first material to form a fin of the first material and a trench adjacent the fin;
- growing alternating layers of a second material and of the first material or a third material in the trench adjacent the fin;
- removing portions of the alternating layers to form a lateral fin adjacent to the fin, the lateral fin comprising alternating portions of the first material or the third material and portions of the second material;
- in case the lateral fin comprises portions of the third material:
- removing the portions of the third material, and
- growing portions of the first material where the portions of the third material were removed;
- removing the portions of second material so as to obtain a fin structure comprising the fin and one or more lateral fin portions formed by the portions of the first material.

2. The method according to claim 1, wherein the step of growing alternating layers comprises the steps of:
- growing first alternating layers of the first material and a second material in a first trench adjacent a first side of the fin, and
- growing second alternating layers of the first material and a second material in a second trench adjacent a second side of the fin, and
wherein the step of removing portions of the alternating layers to form a lateral fin adjacent to the fin comprises the steps of:
- removing portions of the first alternating layers to form a first lateral fin adjacent to the fin, the first lateral fin comprising a first alternating stack comprising first portions of the first material and first portions of the second material;
- removing portions of the second alternating layers to form a second lateral fin adjacent to the fin, the second lateral fin comprising a second alternating stack comprising second portions of the first material and second portions of the second material.

3. The method according to claim 2, wherein the step of growing first alternating layers of the first material is preceded by the steps of:
- covering the fin and the first trench by a mask and
- growing a layer of the second material in the second trench.

4. The method according to claim 3, wherein the lateral fin portions of the first material of the first lateral fin have a different vertical position than the lateral fin portions of the first material of the second lateral fin.

5. A method of manufacturing a fin field effect transistor (finFET), the method comprising the steps of:
- providing a substrate comprising a first material;
- growing a stack of alternating layers of a second material and the first material or a third material on a surface of the first material;
- removing portions of the stack to form a fin shaped cavity;
- growing a fin of the first material inside the fin shaped cavity;
- removing portions of the stack of alternating layers to form a lateral fin adjacent to the fin, the lateral fin comprising alternating portions of the first material or the third material and portions of the second material;
- in case the lateral fin comprises portions of the third material:
- removing the portions of the third material, and
- growing portions of the first material where the portions of the third material were removed;
- removing the portions of second material so as to obtain a fin structure comprising the fin and one or more lateral fin portions formed by the portions of the first material.

6. The method according to claim 5, wherein the fin shaped cavity extends to the surface of the first material.

7. The method according to any of the preceding claims, wherein an etching property of the first material is different from an etching property of the second material.

8. The method according to any of the preceding claims, wherein the first material is Si and the second material is SiGe.

9. The method according to any of the preceding claims, further comprising the step of providing an insulation layer on the fin structure.

10. The method according to claim 9, wherein the insulation layer is provided on the fin structure by means of an oxide deposition or an oxide growth.

11. The method according to any of the preceding claims, further comprising the step of depositing a gate on the fin structure.

12. The method according to claim 11, wherein the gate comprises an n⁺-doped poly silicon layer or a metal stack.

13. A finFET manufactured according to the method of any of the preceding claims.

14. A finFET comprising:
a channel connecting a source and a drain, the channel comprising a fin structure, whereby the fin structure comprises a fin and one or more lateral fin portions.

15. A device comprising one or more finFETs according to claims 13 or 14.
